(19) **Europäisches Patentamt / European Patent Office / Office européen des brevets**

(11) **EP 2 045 913 A1**

(12) **EUROPEAN PATENT APPLICATION**

(43) Date of publication:
**08.04.2009 Bulletin 2009/15**

(51) Int Cl.:
*H03F 1/02* (2006.01)     *H03F 1/56* (2006.01)
*H03F 3/195* (2006.01)     *H03G 1/00* (2006.01)
*H03F 3/189* (2006.01)

(21) Application number: **07117823.0**

(22) Date of filing: **03.10.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **Seiko Epson Corporation
Shinjuku-ku,
Tokyo 163-0811 (JP)**

(72) Inventors:
• **GIL GALI, Ignacio**
  **c/o Epson Europe Electronics
  08190, Sant Cugat del Valles (Barcelona) (ES)**
• **CAIRO MOLINS, Josep Ignasi**
  **c/o Epson Europe
  08190, Sant Cugat del Vallés (Barcelona) (ES)**

(74) Representative: **Carpintero Lopez, Francisco et al
Herrero & Asociados, S.L.
Alcalá 35
28014 Madrid (ES)**

(54) **Low noise amplifier and N-mode gain control circuit therefor**

(57)     A LNA (1) has at least one output coupled to an RF mixer (2). In order to provide the LNA (1) with selectable n-gain modes, a gain control circuit (6) is inserted to its output, which includes at least one transistor, preferably a MOSFET, connected in series to a capacitive impedance. The transistor is biased by a DC voltage which switches its operating point between saturation regime and cut-off regime in correspondence to a low-gain mode and a high-gain mode of the LNA (1) respectively. The capacitance from the capacitive impedance can be changed, by using a bank of capacitors or varactors, in order to vary the gain level of the LNA (1) when operating in the low-gain mode.

The invention also relates to an RF transmitter and/or receiver including the low noise amplifier and mixer front end, and to a method for gain control of said low noise amplifier.

FIG. 1

**Description**

FIELD OF THE INVENTION

The invention relates generally to the field of wireless communications, especially to the operation of Radio Frequency (RF) transceivers. More particularly, the present invention refers to a circuit and a method for controlling low noise amplifier (LNA) gain by means of several gain modes.

STATE OF THE ART

Within the field of radio communication, such as satellite communication or mobile communication, there is an increasing need of low power amplifier stages. For safe information signal recovery with good gain and noise performance, low noise amplifiers (LNAs) are used in this field.

As described in papers, product application notes, and textbooks, there are currently several approaches to the design of a radio frequency (RF) receiver front end, which commonly includes a low-noise amplifier (LNA) followed at its output by a mixer and, at the input of the LNA, an antenna that receives the incoming electromagnetic field and, after a filter stage, provides a single-ended RF input signal. The LNA receives the weak RF input signal from the antenna and amplifies the signal while adding as little noise as possible. The mixer then converts its input signal from its RF frequency to a lower intermediate frequency for further processing by the receiver baseband. In order to produce this intermediate frequency (IF) signal, the mixer subtracts the RF input at the RF frequency from a signal produced by a local oscillator (LO).

When designing the RF receiver front end, the relevant factors include power and voltage gain, noise figure, linearity, and power consumption.

For power consumption reduction, the LNA is preferred to operate with a lower gain, whenever the signal level from the antenna does not need to be amplified with a high gain. That is, a 2-mode gain LNA is desirable. In any of the wireless communications standards, typical requirements for LNAs providing two diferenciated gain modes or states are:

- High gain mode having about 10 to 20 dB power gain.
- Low gain mode showing about 0 to -10dB gain.
- Input and output port matched to system impedance in both gain modes.
- Lowest power consumption in low gain mode.

The high gain of 10 to 20 dB is typically required to fulfill the receiver sensitivity requirements. A low gain of approximately -10dB is often desirable since this allows the LNA to operate in a passive mode at very low power consumption in the low gain state and still provide adequate isolation between the preceding an succeeding passive filters. Operation in low gain mode is usually applied only in cases where the LNA is provided with very high signal level inputs within the signal level working range (therefore, no gain and even an attenuation function is required).

Within an RF transceiver, the receiver chain has then to comply a design requirement of being able to work in at least two different gain modes, depending on the amplitude of the RF signal detected by the antenna. The gain mode switch or change can be performed either in the LNA or in the mixer of the RF receiver Front End. Since the LNA is the block that provides the main power or voltage gain of the complete chain, an inmediate option is to introduce the switchable gain capability in the LNA design. But special care must be taken in order to keep the same LNA structure and not to alter its Scattering or S-parameters, the resulting gain and noise figure.

The voltage gain of the LNA is determined by the real part of its load impedance, which is in turn, when connected to the next stage (typically, a mixer), set basically by the mixer input impedance, the output resistance of the LNA and parasitic resistance of passive elements such as inductor load, capacitors, etc.

DESCRIPTION OF THE INVENTION

An object of the present invention is to provide a low noise amplifier (LNA) with multiple (at least two) selectable gain modes having an improved efficiency and enhanced quality of the output signal in any of the gain states available. Another object of the present invention is to achieve the aforesaid object at a minimised amount of energy consumption reached by an RF front-end circuit having a reduced number of elements and size. An even further object of the present invention is to allow adjustment of the gain without altering the structure of either the LNA either the mixer and without affecting the basic performance of the RF circuit.

One aspect of the invention relates to a low noise amplifier which has a gain control circuit designed to be connected to its output. The low noise amplifier can present a single-ended output or a double-ended output, which is connected to an input of the next stage (to, a mixer or a filter). The proposed gain control circuit modifies matching network (e.g., a typical "L and C" section, a Pi or T network, etc.) between the low noise amplifier and the next stage, which is required to match the respective impedances (typically to 50 Ohms) at the output of the LNA and the input of the next stage, in order to maximize the power transfer (insertion losses) and minimize return losses from the load.

In the Radio Frequency (RF) transceiver front-end, the RF signal interfaces a single-ended or differential input low noise amplifier (LNA) and goes once amplified into a mixer coupled to the output (single ended or differential) of the LNA. The gain of the LNA is adjusted to maximize signal-to-noise ratio of the mixer and to force the mixer to operate well within its linear region when an intermodulation interference component is present. In order to improve the signal-to-noise ratio of an RF signal presented to the mixer by the LNA, the gain and noise of the LNA is adjusted. In adjusting the gain of the LNA, great care must be taken. While maximizing the gain of the LNA serves to increase the Signal to Noise Ratio (SNR) of the RF signal, if the LNA gain is too large, the mixer will be driven into non-linear operation and the intermediate frequency (IF) signal produced by the mixer will be distorted. Thus, it is desirable to have the LNA working in a high gain mode wherein it provides as great an amplification of the received RF signal as possible prior to presenting the amplified RF signals to the mixer without driving the mixer into non-linear operation. But also it is desirable to allow the LNA to work in a low gain mode when a high amplification is not needed in order to reduce power consumption. Therefore, at least 2-mode gain selectable LNA is desirable.

The technique proposed here consists in inserting between the LNA and its next stage (i.e., the mixer or the filter in the reception front-end) at least a switching element connected in series to a capacitive impedance. This switching element, which comprises at least a transistor, is biased by means of a DC (constant polarity) voltage into two states, "on" state and "off" state: the so-called "on" state corresponds to a saturation transistor regime and the off state to the cut-off transistor regime. Such switching element can be just one transistor or a digital circuit integrating several transistors that cooperate as a switching unit (biased by a control system of n-bit output, which can activate the corresponding capacitance or varactor in function of the required amplifier gain) The types of transistors that can be used for the switching element are: PNP or NPN bipolar junction transistors, (BJT) heterojunction bipolar transistors (HBT) and, preferably, MOSFET transistors, which also may be p-channel (PMOS) or n-channel (NMOS).

The DC voltage used to bias the transistor through its gate (if a MOSFET is employed) or its base (if a BJT or HBT is employed) can be determined by either a digital or an analog voltage signal.

The saturation regime of said transistor(s) is reached, when biased by applying to its gate, if a MOSFET is used, the DC voltage with a certain value ($V_G$) so that a channel can be created to allow current to flow between the drain and source of the MOSFET transistor. Therefore, the switching element is turned on.

For example, in case that a n-channel MOSFET (NMOS) is used, the saturation regime is reached when $v_{GS} > V_{th}$ and $V_{DS} > V_{GS} - V_{th}$, being $V_{GS}$ and $V_{DS}$ the gate voltage and the drain voltage values respectively and both measured relative to the source voltage, and $V_{th}$ is the threshold voltage of the transistor that makes it turn off interrupting conduction between drain and source. Since the drain voltage is higher than the gate voltage, a portion of the created channel is turned off. The drain current is then relatively independent of the drain voltage and the drain current ($I_D$) is controlled by only the gate-source voltage ($V_{GS}$) and cab be modeled as:

$$I_{DS} = \frac{\mu_n C_{ox}}{2} \frac{W}{L} \left[ \left( V_{GS} - V_{th} \right)^2 \right] \qquad \text{(equation 1)}$$

In equation 1, the following parameters of the transistor are considered:

charge-carrier effective mobility ($\mu_n$),
gate oxide capacitance per unit area ($C_{ox}$),
the gate width (W), and
the gate length (L).

A similar behaviour is expected if a BJT or HBT transistor takes the place of the MOSFET as explained, considering in this context that the gate of a MOSFET is equivalent to the base of a bipolar transistor, as well as the drain and the source of the MOSFET correspond to the collector and the emitter respectively of the bipolar transistor.

With the switching element biased in this "on" state, the effective capacitance at the LNA output is increased due to the capacitive impedance connected in series to said switching element. This fact implies a mismatching (the decreasing of the matching) and thus, the gain is decreased, that is a Low Gain Mode (LGM) is obtained. The degree of gain variation depends directly on the value of the added capacitive impedance. A single capacitor or a bank of capacitive elements, composed by a plurality of capacitors that gives a total capacitance equal to the sum of the individual capacitances, can be connected in series to the switching element. Another possible option for the capacitive impedance is to vary the capacitor (or bank of capacitors) by using one or more varactors connected between a switching control circuit and a biasing network. This switching control circuit selects one or several varicaps in function of the required equivalent capacitance in terms of gain performance. The corresponding biasing network of said varactor(s) can be conveniently designed to apply the different voltage values on the respective terminals of the varactors in order to get a variable capacitance.

Concerning the "off" state of the switching element, since the equivalent circuit of the added block, formed by said switching element in series to the capacitive impedance (one capacitor/varactor or various capacitors/varactors summing up their respective capacitance values), corresponds to an open circuit. Therefore, no real impedance contribution is provided to the output, which means that the LNA and so the global front-end circuit remains in High Gain Mode (HGM), preserving the LNA output matching and the maximum amplifier gain.

In the case of having a differential output LNA, the aforementioned block of switching element+capacitive impedance can be added to each of the two LNA output branches. A possible alternative is incorporating in the gain control circuit a balun connected to the LNA in order to make the differential RF signal at said differential output into a single RF signal, so that just one block of switching element+capacitive impedance is needed to be connected to the balun output.

Using (n-1) different values for the capacitance provided by the capacitive impedance, a LNA with selectable n-gain modes is achieved, being n≥1. The most usual case regards to 2-gain levels: a high-gain mode (HGM) and a unique low-gain mode (LGM) achieved by connecting a single capacitor/varactors in series to the switching element. If a bank of n capacitor/varactors constitutes the capacitive impedance, (n-1) number of low-gain mode is obtained,

The added block for gain control does not involve extra power consumption requirements because the capacitive impedance stops the flow of DC current. There is no power consumption at all from this block, if the switching element consists of a transistor; in case that a digital circuit is used as the switching element, its consumption is still negligible.

Another aspect of the invention relates to a method for gain control of a low noise amplifier, in a RF front-end circuit, which comprises the steps of:

- connecting to the output of the low noise amplifier at least one switching element, comprising at least one transistor (either a PMOS or an NMOS transistor, either a PNP or NPN bipolar transistor), in series to a capacitive impedance;
- biasing the switching element by a DC voltage to commute between two states (operating points of said switching element) in correspondence to at least two gain modes of the LNA: a saturation regime of said transistor corresponds to a low-gain mode of the LNA and a cut-off regime of said transistor corresponds to a high-gain mode of the LNA.

Additionally, this method for gain control of the low noise amplifier may comprise, when the transistor is operating in saturation regime, a further step of setting a gain level of the LNA by changing the total capacitance value of the capacitive impedance. The mismatching level needed to decrease the gain is given by the relative capacitance value modified with regards to the capacitance matching value.

From the n-gain mode point of view, the number of selectable modes depends on the number of capacitors, and there is complete freedom for the designer in that sense. Another aspect of the invention relates to an RF transmitting and/or receiving unit that contains a low noise amplifier and a gain control circuit, connected to the output of low noise amplifier, implementing the described method.

BRIEF DESCRIPTION OF THE DRAWINGS

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied. The drawings comprise the following figures:

Figures 1 shows a block diagram of a low noise amplifier and mixer front-end circuit in accordance with an embodiment of the invention.
Figure 2 shows a schematic representation of a single ended to differential low noise amplifier and mixer front-end circuit including a detailed representation, in accordance with a possible embodiment, of the gain control block at the differential output of the low noise amplifier.
Figure 3 shows a schematic representation of a differential low noise amplifier and mixer front-end circuit including a detailed representation, in accordance with another possible embodiment, of the gain control block at the differential output of the low noise amplifier.
Figure 4 shows a schematic representation of a differential low noise amplifier and mixer front-end circuit including a detailed representation, in accordance with another further possible embodiment, of the gain control block at the differential output of the low noise amplifier.
Figure 5 shows a graphical representation of transmission S-parameter (insertion losses) obtained by simulation in the low noise amplifier and mixer front-end circuit of Figure 3 operating for four gain modes.

Figure 6 shows a graphical representation of noise figure measurements obtained by simulation in the low noise amplifier and mixer front-end circuit of Figure 3 operating for four gain modes.

## DESCRIPTION OF A PREFERRED EMBODIMENT OF THE INVENTION

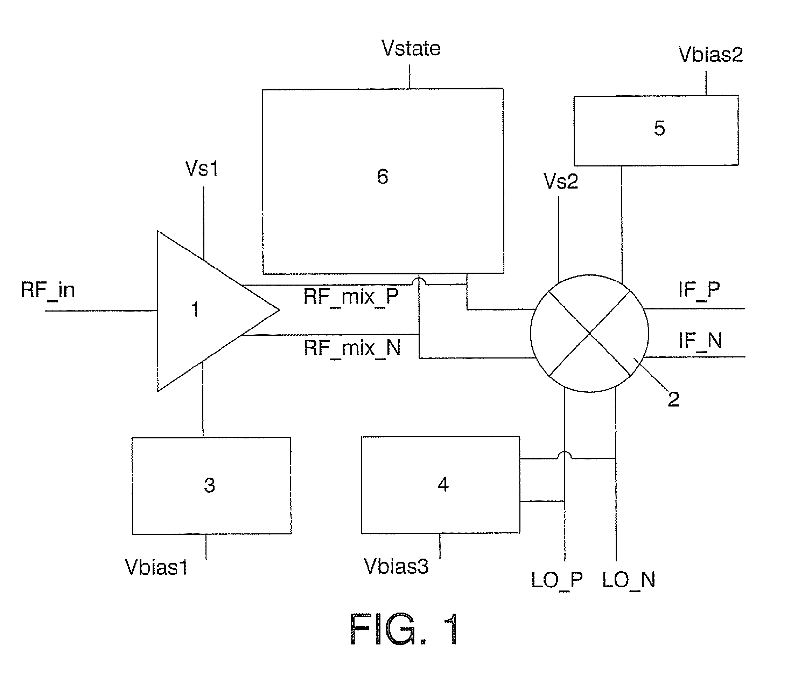

An RF receiver front-end constructed according to one possible embodiment of the present invention, as illustrated in Figure 1, comprises a low noise amplifier or LNA (1), coupled to an antenna and filter that are not represented in this Figure, which adjusts with gain a received RF input signal (RF_in). In this example, the LNA (1) presents a single-ended input and differential output and is biased by a first biasing voltage ($V_{bias1}$) generated by a LNA biasing network (3). Coupled to the output of said LNA (1), at which amplified RF differential signals (RF_mix_P, RF_mix_N) are delivered, the RF front-end includes a mixer (2) correspondingly biased by a second biasing voltage ($V_{bias2}$), which is generated by a mixer biasing network (5) . Additionally, the LNA (1) and the mixer (2) are supplied directly by respective DC supply voltages (Vs1, vs2) . The mixer (2) mixes the level adjusted signals (RF_mix_P, RF_mix_N) aforementioned at the output of the LNA (1) with input signals (LO_P, LO_N) from a Local Oscillator or LO, not shown in the Figure 1, which in turn has its LO biasing network (4) providing a third biasing voltage ($V_{bias3}$) for this LO. At the output of the mixer (2) a signal about an Intermediate Frequency is generated at each of its two output branches, that is, IF differential signals (IP_P, IF_N) are produced. In Figure 1, the references P and N of the signals denotes the positive and negative branches of the corresponding differential signal.

In order to select the operation mode of the LNA (1) and adjust the gain level that determines each operation mode, this RF receiver front-end comprises a gain control circuit (6) connected between the output of said LNA (1) and the input of said RF mixer (2), by means of which n-mode gain is selectable for said LNA (1). For this purpose, the gain control circuit (6) in turn comprises at least one transistor (7) biased by a DC voltage (Vstate) and connected in series to a capacitive impedance.

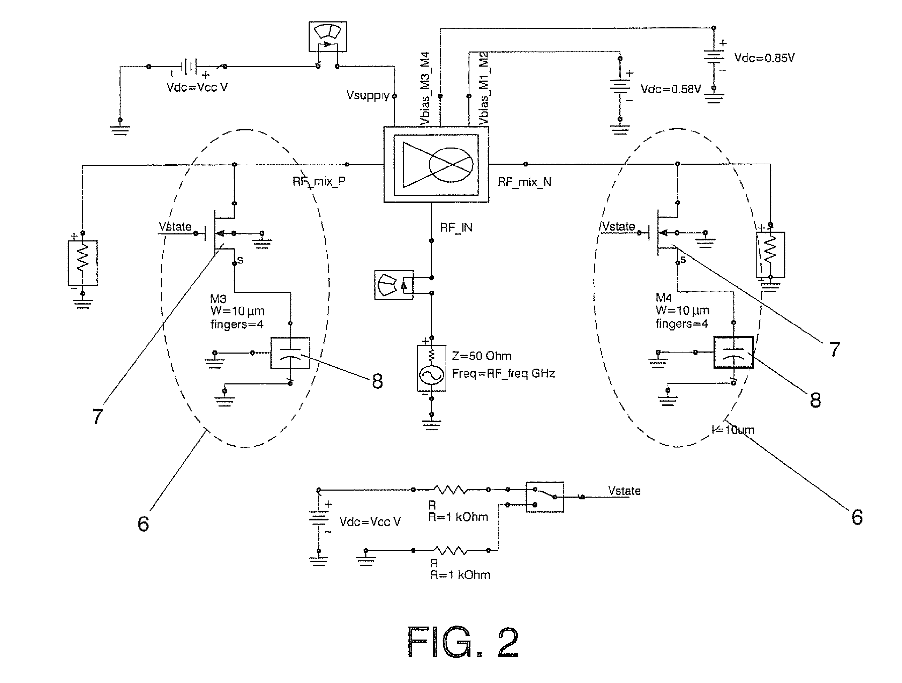

A possible implementation of this gain control circuit (6) which is quite simple consists of connecting a transistor (7) in series to a capacitor (8), as illustrated in Figure 2, being the transistor (7) used in the example a NMOS. Such block of gain control circuit (6) composed by one transistor (7) and one capacitor (8) is connected to each of the two output branches at which the respective RF differential signals (RF_mix_P, RF_mix_N) are delivered.

In Figure 2, the NMOS branch is used as a switch by properly biasing its gate with a DC voltage (Vstate) which is changed to commute between the saturation transistor regime and the cut-off transistor regime. The RF front-end circuit shown in Figure 2 is fed by a supply voltage (V supply) from a Vdc = Vcc volt power supply; other input DC voltages are the biasing voltage signals (Vbias_M3_M4, Vbias_M1_M2) respectively for the transistor pair M3-M4 and the transistor pair M1-M2, not shown, which constitute the low noise amplifier and the transconductance stage of the mixer in this example.

Since the topology presents DC blocking, due to the series capacitor, there is no current flowing through the added structure. As a result, the NMOS branch does not consume DC current and it can act as a bypass switch by simply change its DC operating point between the saturation region an the off state.

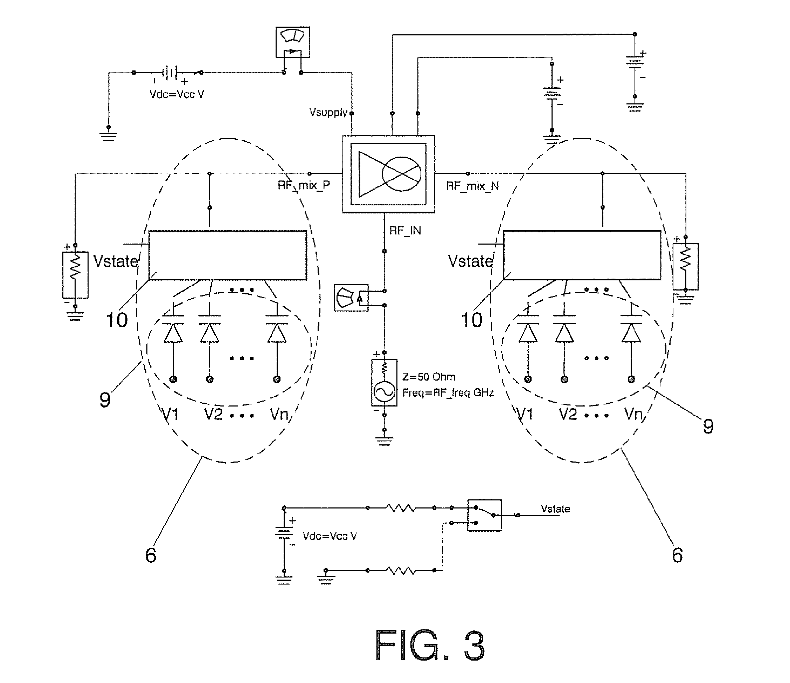

Another possible implementation of the gain control circuit (6) for a single ended to differential low noise amplifier and mixer front-end circuit is the one represented in Figure 3, wherein a set of varactors (9) is used, instead of the capacitor (8), in order to adjust the required equivalent capacitance in terms of gain performance at the output of the low noise amplifier. Since the example of Figure 3 illustrates a front-end circuit with a single-ended input and differential output, two blocks constituting the gain control circuit (6) are inserted in this front-end circuit. Each block has the set of varactors (9) connected in series to an integrated digital circuit (10) that acts as a switching element to select a desired subset of the varactors (9) in order to commute to a determined gain mode, having up to a number (n) of different low-gain modes equal to the number (n) of varactors (9) in the set. Each of said varactors (9) is biased by a respective voltage (V1, V2,..., Vn) generated by an appropriate biasing network, not shown in Figure 3. A DC voltage (Vstate) is used for biasing of the transistors integrated in the digital circuit (10) to switch their operating point conveniently from the cut-off regime to the saturation region.

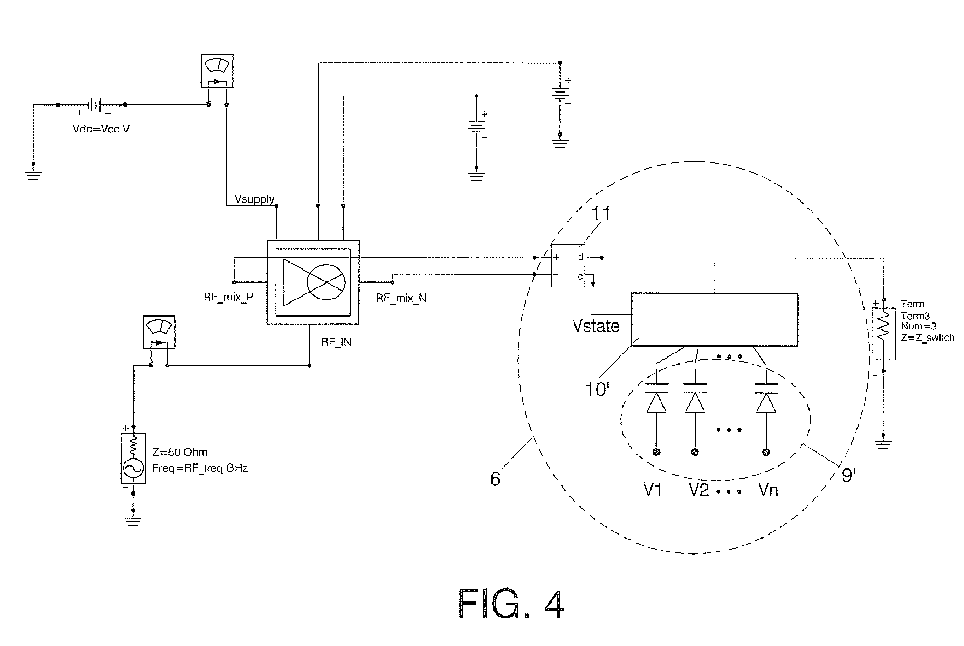

Figure 4 illustrates a last example of implementation of a low noise amplifier and mixer front-end circuit incorporating the gain control circuit (6), wherein a balun (11) circuit is included for performing a differential signal conversion to a single-ended output signal from the low noise amplifier. The balun (11) circuit has a balanced single output and two inputs: a positive phase input coupled to the positive phase output of the differential low noise amplifier depicted in Figure 4, and a negative phase input coupled to the negative phase output of this differential amplifier. The output of the lead network and the delay element are combined to form a single-ended output. The output impedances of the positive and negative phase outputs can be properly adjusted by means of said balun (11) circuit so that the output impedance of its single-ended output is set to a desired value. Then, just one block for gain control of the low noise amplifier is needed to be connected to the single-ended output provided by said balun (11) circuit, being the only block composed by a n-ary set of varactors (9') connected to a corresponding integrated digital circuit (10') governed by a DC voltage (Vstate) and acting as a switching element over the varactors (9').

The following table shows some parameters indicatory of low noise amplifier performance: Gain, Noise Figure (NF), Third-Order Input Intercept Point (IIP3), Phase differential and stability K-factor. These parameters have been measured in a RF front-end circuit with an operating frequency (freq) of 2.45 GHz, which includes a gain control circuit (6) comprising a bank of five capacitors to obtain a 6-gain mode variation in the low noise amplifier. In order to automatically switch the gain mode by commuting from a capacitance value to another from the bank of capacitors, a NMOS transistor is used as the switching element; more particularly, a NMOS having a gate with for fingers a width of 10 $\mu$m is connected in series to the five capacitor bank, conforming the gain control circuit to be connected to the low noise amplifier output. The resulting values of these parameters are not affected by the used switching element, because the transistor here has just one function: on/off to connect/disconnect the required capacitive impedance to the output of the low noise amplifier.

| Capacitance (pF) | MODE | Gain (dB) | NF (dB) | IIP3 (dBm) | Phase differential (deg) | K factor |
|---|---|---|---|---|---|---|
| - | HGM | 15.3 | 3.8 | -12.9 | 180.1 | 10.3 |
| 10um×10um | LGM1 | 10.0 | 3.8 | -19.7 | 180.7 | 12.6 |
| 15um×15um | LGM2 | 6.1 | 3.8 | -24.7 | 181.2 | 18.2 |
| 20um×20um | LGM3 | 2.5 | 3.9 | -28.3 | 181.7 | 30.9 |
| 25um×25um | LGM4 | -0.4 | 3.9 | -31.0 | 182.1 | 53.7 |
| 30um×30um | LGM5 | -2.8 | 4.0 | -32.9 | 182.3 | 87.0 |

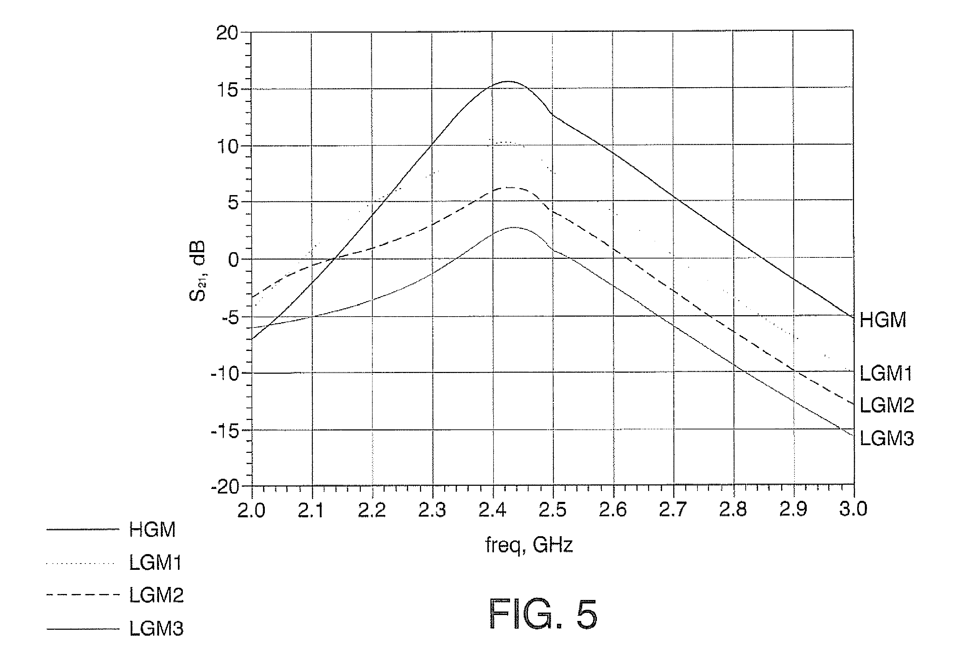

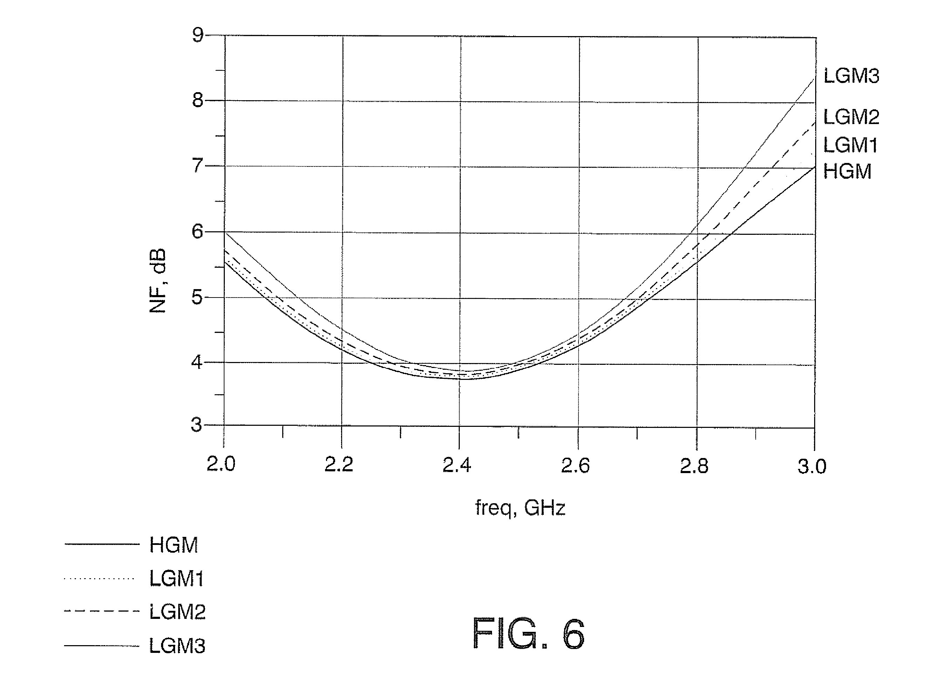

Some simulations corresponding to some gain modes associated to the previous table have been performed and the results of the fundamental parameters involved in LNA performance, i.e, gain and noise, are shown respectively in Figures 5 and 6. In particular, four gain modes: a high-gain mode (HGM) and three different low-gain modes (LGM$_i$) have been considered. For obtaining these four gain modes, three different capacitances can be used or another option is a set of varactors like the one depicted in Figures 3-4.

Figure 5 shows the insertion losses measured by the transmission parameter ($S_{21}$) . As it can be seen, a variable maximum gain is achieved, between 3 and 16 dB, by means of four gain modes with no degradation in the $S_{21}$ response. Note that the low-gain modes (LGM$_i$) are required when the received RF input signal (RF_in) presents a high level and, in this case, gain level and noise requirements are less strict than for the high-gain mode (HGM).

Figure 6 shows noise performance, given by the Noise Figure (NF), and no real impact is observed, since the gain control circuit (6) is inserted at the output of the LNA of the circuit. This fact allows to properly increase/reduce power gain with no significant degradation in the overall signal to noise ratio.

In the context of the present invention, the term "approximately" should be understood as indicating values very near to those which accompany the aforementioned term and the same applies to the terms "about" and "around". That is to say, a deviation within reasonable limits from an exact value should be accepted, because a skilled person in the art will understand that such a deviation from the values indicated is inevitable due to measurement inaccuracies, etc.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

Some preferred embodiments of the invention are described in the dependent claims which are included next.

**Claims**

1. Variable-gain low noise amplifier comprising:

   a LNA (1) that has at least one output
   and a gain control circuit (6) connected to the, at least one, output of said LNA (1),

   **characterised in that** the gain control circuit (6) comprises at least one transistor connected in series to a capacitive impedance, having the transistor a gate, or a base, biased by a DC voltage which switches said transistor operating point between saturation regime and cut-off regime in correspondence to at least two gain modes of the LNA (1).

2. Variable-gain low noise amplifier according to claim 1, wherein the at least one transistor is a bipolar transistor, having a base biased by a DC voltage which switches said transistor operating point between saturation regime and cut-off regime in correspondence to at least two gain modes of the LNA (1) .

3. Variable-gain low noise amplifier according to claim 1, wherein the at least one transistor is a MOSFET, having a gate biased by a DC voltage which switches said transistor operating point between saturation regime and cut-off regime in correspondence to at least two gain modes of the LNA (1).

4. Variable-gain low noise amplifier according to claim 3, wherein the at least one transistor is a PMOS.

5. Variable-gain low noise amplifier according to claim 3, wherein the at least one transistor is a NMOS.

6. Variable-gain low noise amplifier according to any of the preceding claims, wherein the LNA (1) has a differential output and the gain control circuit (6) further comprises a balun (11) connected between the differential output of said LNA (1) and the at least one transistor.

7. Variable-gain low noise amplifier according to any of the preceding claims, wherein the capacitive impedance comprises at least a varactor.

8. Variable-gain low noise amplifier according to any of the preceding claims, wherein the capacitive impedance comprises at least a capacitor.

9. variable-gain low noise amplifier according to claim 8, wherein the capacitive impedance comprises a plurality of shunt capacitors.

10. A radiofrequency transmitting and/or receiving unit comprising a variable-gain low noise amplifier according to at least one of the preceding claims.

11. A radiofrequency transmitting and/or receiving unit according to claim 10, **characterized in that** it makes part of a mobile user equipment such as a mobile telephone or a Bluetooth device.

12. Method for gain control in a radiofrequency front end circuit which includes a LNA (1) with at least one output, comprising the steps of:

    - connecting to the at least one output of the LNA (1) at least one transistor in series to a capacitive impedance,
    - biasing said transistor by a DC voltage to commute between a saturation regime and a cut-off regime of operation in correspondence to at least two gain modes of the LNA (1) .

13. Method according to claim 12, further comprising a step of setting a total capacitance from the capacitive impedance to vary the gain level of the LNA (1) while the transistor is biased in the saturation regime.

14. Method according to claim 13, wherein the step of setting the total capacitance comprises biasing at least a varactor by a biasing voltage and varying said biasing voltage.

FIG. 1

EP 2 045 913 A1

FIG. 2

FIG. 3

FIG. 4

FIG. 5

FIG. 6

EP 2 045 913 A1

**European Patent Office**

**EUROPEAN SEARCH REPORT**

Application Number

EP 07 11 7823

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 450 483 A (SIEMENS AG [DE]) 25 August 2004 (2004-08-25) * paragraphs [0001], [0017] - [0020]; figures 2a,2b * ----- | 1-14 | INV. H03F1/02 H03F1/56 H03F3/195 H03G1/00 H03F3/189 |
| X | US 5 276 912 A (SIWIAK KAZIMIERZ [US] ET AL) 4 January 1994 (1994-01-04) * column 1, lines 58-63; figures 5,6 * * column 3, line 32 - column 4, line 54 * ----- | 1-14 | |
| A | WO 2007/043122 A (FUJITSU LTD [JP]; ARAI TOMOYUKI [JP]) 19 April 2007 (2007-04-19) * abstract; figures 1,2,4-7 * ----- | 1-14 | |

TECHNICAL FIELDS
SEARCHED (IPC)

H03F
H03G
H03H

The present search report has been drawn up for all claims

| Place of search | Date of completion of the search | Examiner |
|---|---|---|
| The Hague | 23 April 2008 | Goethals, Filip |

EPO FORM 1503 03.82 (P04C01)

**ANNEX TO THE EUROPEAN SEARCH REPORT
ON EUROPEAN PATENT APPLICATION NO.**

EP 07 11 7823

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2008

| Patent document cited in search report | | Publication date | Patent family member(s) | Publication date |
|---|---|---|---|---|
| EP 1450483 | A | 25-08-2004 | NONE | |
| US 5276912 | A | 04-01-1994 | NONE | |
| WO 2007043122 | A | 19-04-2007 | NONE | |

EPO FORM P0459

For more details about this annex : see Official Journal of the European Patent Office, No. 12/82